(19) **Europäisches Patentamt European Patent Office Office européen des brevets**

(11) **EP 1 811 568 B1**

(12) **FASCICULE DE BREVET EUROPEEN**

(45) Date de publication et mention de la délivrance du brevet:
**17.03.2010 Bulletin 2010/11**

(51) Int Cl.:
***H01L 27/092*** *(2006.01)*

(21) Numéro de dépôt: **07000663.0**

(22) Date de dépôt: **15.01.2007**

(54) **Dispositif de protection d'un circuit intégré contre les phénomènes de déclenchement parasite**

Schutzschaltung für eine integrierte Schaltung gegen parasitäre latch-up Phänomene

Device for protecting an integrated circuit against latch-up phenomena

(84) Etats contractants désignés:
**DE FR GB IT**

(30) Priorité: **24.01.2006 FR 0600607**

(43) Date de publication de la demande:
**25.07.2007 Bulletin 2007/30**

(73) Titulaire: **STMICROELECTRONICS SA 92120 Montrouge (FR)**

(72) Inventeur: **Tailliet, Francois 13710 Fuveau (FR)**

(74) Mandataire: **de Roquemaurel, Bruno OMNIPAT 24 Place des Martyrs de la Résistance 13100 Aix en Provence (FR)**

(56) Documents cités:
**EP-A- 0 391 672      EP-A- 0 827 206
WO-A- 02/00004      US-A- 5 212 616
US-A- 5 977 815      US-A1- 2003 222 703**

- **PATENT ABSTRACTS OF JAPAN vol. 015, no. 299 (E-1095), 30 juillet 1991 (1991-07-30) -& JP 03 106068 A (FUJITSU LTD; others: 01), 2 mai 1991 (1991-05-02)**
- **PATENT ABSTRACTS OF JAPAN vol. 018, no. 688 (P-1849), 26 décembre 1994 (1994-12-26) -& JP 06 273481 A (ISHIKAWAJIMA HARIMA HEAVY IND CO LTD), 30 septembre 1994 (1994-09-30)**

**Description**

La présente invention concerne les circuits intégrés et plus particulièrement la protection des circuits intégrés contre les phénomènes dits de "verrouillage" ou de "déclenchement parasite" (latch up).

Elle s'applique notamment, mais non exclusivement aux technologies de circuits intégrés de type CMOS (Complementary Metal-Oxide Semiconductor) qui sont particulièrement sensibles à ce phénomène.

Le phénomène de déclenchement parasite se manifeste par un appel de courant lié au déclenchement d'une structure de thyristor parasite inhérente à certaines technologies de circuits intégrés, et en particulier aux technologies de type CMOS.

Les architectures à base de transistors MOS, comportent des transistors bipolaires parasites dont le gain peut être très élevé (50 à 100). Les transistors parasites ne présentent donc pas de nuisance pour le fonctionnement du circuit, sauf dans certaines configurations de type thyristor parasite (PNPN) dans lesquelles deux transistors bipolaires parasites travaillent en contre-réaction positive, formant une configuration bistable qui peut être déclenchée par de faibles perturbations. Une fois la contre-réaction établie, le thyristor se trouve dans un état de forte conduction qui s'autoalimente même après la disparition de la perturbation, du fait que le thyristor est placé directement en parallèle sur l'alimentation. Cet état peut donc s'avérer destructif pour le circuit intégré.

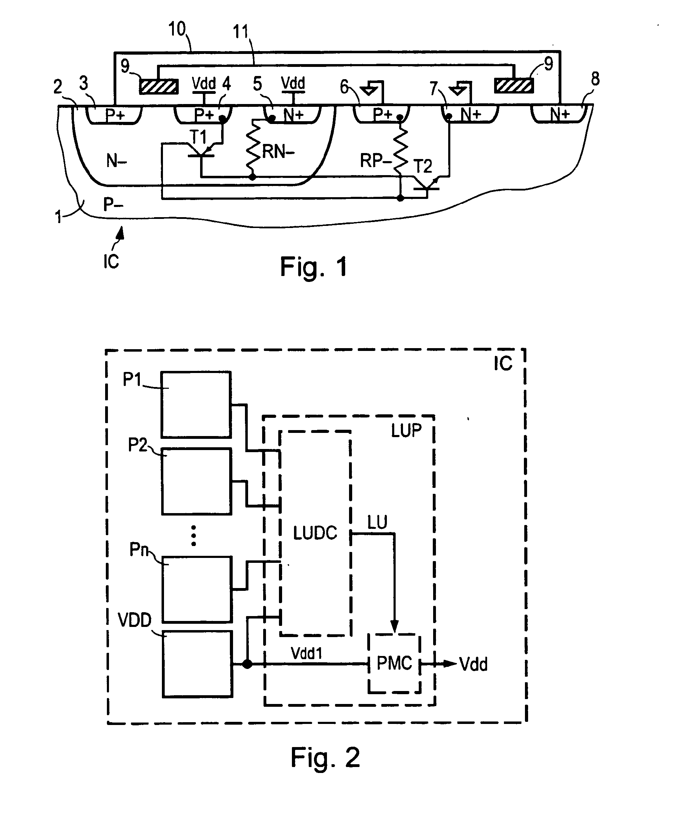

Une telle configuration de thyristor parasite est illustrée par la figure 1 qui représente en coupe la structure d'une cellule de circuit intégré CMOS, comportant par exemple une porte logique telle qu'un inverseur.

La cellule de circuit intégré IC représenté sur la figure 1, de type à substrat P et caisson N, comprend deux transistors MOS à canal P et N, réalisés dans un substrat semi-conducteur 1 dopé P-. Le transistor MOS à canal P est formé dans une région 2 dopée N- du substrat, appelée "caisson". Le caisson comprend une région de drain 3, une région de source 4, ces régions étant dopées P+, et une région 5 dopée N+. Les régions 3, 4 qui délimitent le canal du transistor MOS à canal P, sont connectées respectivement à une sortie 10 de la cellule et à la borne d'alimentation Vdd. La région 5 reçoit la tension d'alimentation Vdd. Le transistor MOS à canal N est formé dans le substrat 1 par une région de source 7, une région de drain 8, ces régions étant dopées N+ et délimitant le canal du transistor MOS à canal N, et une région 6 dopée P+ connectée à la masse. Les régions 7, 8 sont connectées respectivement à la borne de masse et à la sortie 10 de la cellule.

Des couches 9 par exemple en polysilicium formées au dessus des canaux N et P des deux transistors, constituent les grilles de ces derniers et sont connectées à l'entrée 11 de la cellule de circuit intégré.

La figure 1 représente également en traits plus fins la disposition du thyristor parasite par rapport aux régions dopées formant les deux transistors MOS. Le thyristor parasite est formé par deux transistors bipolaires T1 de type pnp et T2 de type npn, montés tête-bêche, le collecteur de l'un étant connecté à la base de l'autre, tandis que les émetteurs des deux transistors T1, T2 sont respectivement connectés à la borne d'alimentation Vdd et à la masse du circuit. La jonction émetteur-base du transistor T1 est formée par l'association des régions 4 dopée P+ et 2 dopée N-, tandis que la jonction collecteur-base de ce transistor est formée par l'association du substrat 1 dopé P- et de la région 2 dopée N-. La borne d'alimentation Vdd du circuit est donc connectée à l'émetteur du transistor T1, et reliée à la base de ce transistor par l'intermédiaire d'une résistance RN- représentant la résistance du caisson 2. La jonction base-émetteur du transistor T2 est formée par l'association du substrat 1 et de la région 7 dopée N+ reliée à la masse, tandis que la jonction base-collecteur de ce transistor est formée par l'association du substrat 1 et de la région 2. La masse est donc connectée à la base du transistor T2, et reliée à l'émetteur de ce transistor par l'intermédiaire d'une résistance RP- représentant la résistance du substrat 1.

Le thyristor parasite peut être déclenché par une surtension appliquée sur l'alimentation du circuit intégré, une tension négative ou une surtension appliquée sur une borne d'entrée et/ou de sortie du circuit intégré, une injection de courant dans une borne d'entrée ou de sortie du circuit intégré, ou encore par des rayonnements de particules. Ce déclenchement produit un fort appel de courant entre les bornes d'alimentation du circuit intégré, qui peut provoquer la destruction du circuit intégré.

Les spécifications des circuits intégrés imposent un minimum de courant injecté, par exemple 100 mA à la température maximum de fonctionnement (généralement comprise entre 70 et 150°C).

La sensibilité d'un circuit intégré au déclenchement parasite peut être mesurée en injectant un courant dans une patte d'entrée ou de sortie du circuit intégré, tandis que celui-ci est alimenté normalement, en détectant une surconsommation de courant dans l'alimentation, qui peut être plus ou moins brutale, et en mesurant l'intensité du courant injecté à l'apparition de la surconsommation. Si la surconsommation détectée cesse avec l'injection de courant, le déclenchement parasite est dit temporaire. Si au contraire cette surconsommation se maintient même après l'arrêt de l'injection de courant, le déclenchement parasite est dit permanent. Un circuit est considéré peu sensible au déclenchement parasite si celui-ci n'est que temporaire ou si un déclenchement parasite permanent n'apparaît qu'avec un courant injecté ayant une intensité élevée.

Il existe plusieurs techniques pour réduire la sensibilité des composants au déclenchement parasite, c'est-à-dire réduire les performances du thyristor parasite et la valeur des résistances de base RN- et RP-des deux transistors parasites T1, T2.

Une première technique consiste à appliquer des règles de routage particulières, et notamment à ajouter de nombreuses régions de polarisation N et P, telles que les régions 5, 6 sur la figure 1, et à augmenter la distance entre les transistors MOS à canal N et P. Cette technique va à l'encontre de la miniaturisation des circuits intégrés.

Une autre technique consiste à utiliser des substrats épitaxiés, de manière à réduire la résistance de base de l'un des deux transistors parasites, c'est-à-dire dans l'exemple de la figure 1, la résistance de base RP- du transistor T2. Cette technique implique l'utilisation de plaquettes de silicium plus onéreuses.

On peut également réduire la résistance de base des transistors T1, T2 à l'aide de caissons réalisés en profondeur dans le substrat et fortement dopés. Cette technique contribue également à augmenter les coûts de fabrication, du fait qu'elle nécessite l'ajout ou la modification de plusieurs masques de fabrication du circuit intégré, et augmente le nombre d'étapes de fabrication.

En outre, les techniques présentées précédemment ne sont pas toujours infaillibles.

JP 06273481 décrit un méthode de détection d'un état de déclenchement parasite par un courant dans une diode.

US 5,212,616 décrit un circuit de protection d'un circuit intégré contre les effets de phénomène de latch-up. La tension d'alimentation du circuit intégré est comparée à une tension de référence représentative. Si la tension d'alimentation est inférieure à la tension de référence, un transistor et le régulateur de tension sont désactivés.

La présente invention a pour but de remédier à ces inconvénients. Ainsi, une idée de l'invention est de prévoir un moyen de détection d'une condition de déclenchement parasite, et de modifier une caractéristique de la tension d'alimentation du circuit intégré si une telle condition est détectée, afin d'empêcher un établissement permanent du déclenchement parasite.

Plus particulièrement, l'invention prévoit un procédé de protection d'un circuit intégré. Selon l'invention, le procédé comprend des étapes consistant à détecter un courant dans une diode formée à proximité d'une borne de connexion du circuit intégré, le courant détecté variant en fonction d'un coutant injecté dans la borne de connexion, et modifier un paramètre de tension d'alimentation du circuit intégré si le courant détecté est supérieur à un seuil d'intensité de courant, pour empêcher un établissement permanent d'une condition de déclenchement parasite.

Selon un mode de réalisation de l'invention, le courant détecté dans la diode varie en fonction d'un courant positif injecté dans la borne de connexion.

Selon un mode de réalisation de l'invention, le courant détecté dans la diode varie en fonction d'un courant négatif injecté dans la borne de connexion.

Selon un mode de réalisation de l'invention, la modification d'un paramètre de tension d'alimentation du circuit intégré est effectuée seulement si le courant détecté est toujours supérieur au seuil d'intensité de courant à l'échéance d'une temporisation.

Selon un mode de réalisation de l'invention, le procédé comprend la détection d'une surtension apparaissant dans une borne de connexion d'alimentation du circuit intégré.

Selon un mode de réalisation de l'invention, la modification d'un paramètre de tension d'alimentation du circuit intégré comprend la coupure de la tension d'alimentation du circuit intégré tant qu'une condition de déclenchement parasite est présente.

Selon un mode de réalisation de l'invention, la modification d'un paramètre de tension d'alimentation du circuit intégré comprend un abaissement de la tension d'alimentation du circuit intégré tant qu'une condition de déclenchement parasite est présente.

Selon un mode de réalisation de l'invention, la modification d'un paramètre de tension d'alimentation du circuit intégré comprend la fourniture de la tension d'alimentation du circuit intégré au travers d'une résistance tant qu'une condition de déclenchement parasite est présente.

L'invention concerne également un dispositif de protection d'un circuit intégré comprenant un dispositif de détection d'une condition de déclenchement parasite, et un dispositif de contrôle d'une tension d'alimentation du circuit intégré. Selon l'invention, le dispositif de détection comprend une diode formée à proximité d'une borne de connexion du circuit intégré et un circuit de détection de courant pour détecter un courant traversant la diode, le courant détecté variant en fonction d'un courant injecté dans la borne de connexion, le dispositif de contrôle étant configuré pour modifier un paramètre de la tension d'alimentation du circuit intégré si le courant détecté est supérieur à un seuil d'intensité de courant, afin d'empêcher un établissement permanent du déclenchement parasite.

Selon un mode de réalisation de l'invention, le courant détecté dans la diode varie en fonction d'un courant négatif injecté dans une borne de connexion du circuit intégré.

Selon un mode de réalisation de l'invention, le courant détecté dans la diode varie en fonction d'un courant positif injecté dans une borne de connexion du circuit intégré.

Selon un mode de réalisation de l'invention, le dispositif de détection d'une condition de déclenchement parasite comprend pour chaque borne de connexion du circuit intégré, un circuit de détection d'une injection de courant négatif dans la borne de connexion, et/ou un circuit de détection d'une injection de courant positif dans la borne de connexion.

Selon un mode de réalisation de l'invention, le dispositif de détection d'une condition de déclenchement parasite comprend un circuit de temporisation pour prendre en compte une détection d'injection de courant dans une borne de connexion du circuit intégré, seulement si à la fin d'une durée de temporisation, une injection de courant est toujours détectée.

Selon un mode de réalisation de l'invention, le dispositif de détection d'une condition de déclenchement parasite comprend un circuit de détection d'une surtension apparaissant dans une borne de connexion d'alimentation du circuit intégré.

Selon un mode de réalisation de l'invention, le dispositif de contrôle de tension d'alimentation comprend des moyens de coupure de la tension d'alimentation du circuit intégré tant qu'une condition de déclenchement parasite est présente.

Selon un mode de réalisation de l'invention, le dispositif de contrôle de tension d'alimentation comprend un abaisseur de tension pour abaisser la tension d'alimentation du circuit intégré tant qu'une condition de déclenchement parasite est présente.

Selon un mode de réalisation de l'invention, le dispositif de contrôle de tension d'alimentation comprend une résistance au travers de laquelle la tension d'alimentation est fournie au circuit intégré tant qu'une condition de déclenchement parasite est présente.

Selon un mode de réalisation de l'invention, le dispositif de contrôle de tension d'alimentation comprend un régulateur de tension qui abaisse la tension d'alimentation du circuit intégré à une valeur minimum tant qu'une condition de déclenchement parasite est présente.

L'invention concerne également un circuit intégré comprenant un dispositif de protection tel que défini ci-avant.

Ces objets, caractéristiques et avantages ainsi que d'autres de la présente invention seront exposés plus en détail dans la description suivante de modes de réalisation de l'invention, faite à titre non limitatif en relation avec les figures jointes parmi lesquelles :

- la figure 1 déjà décrite représente en coupe un circuit intégré dans lequel un déclenchement parasite est susceptible de se produire,
- la figure 2 représente sous la forme de blocs un circuit intégré équipé d'un dispositif de protection selon l'invention,
- la figure 3 représente sous la forme de blocs un dispositif de détection de conditions de déclenchement parasite, du dispositif de protection selon l'invention,
- la figure 4 est un schéma électrique d'un circuit de détection selon l'invention, d'une injection de courant négatif sur une borne de connexion du circuit intégré,
- la figure 5 est un schéma électrique équivalent du circuit de détection représenté sur la figure 4,
- la figure 6 est une vue de dessus partielle simplifiée du circuit intégré équipé d'un moyen de détection du circuit représenté sur la figure 4,
- la figure 7 est un schéma électrique d'un circuit de détection selon l'invention, d'une injection de courant positif sur une borne connexion du circuit intégré,
- la figure 8 est un schéma électrique équivalent du circuit de détection représenté sur la figure 6,
- la figure 9 est une vue de dessus partielle simplifiée du circuit intégré équipé d'un moyen de détection du circuit représenté sur la figure 7,
- la figure 10 est un schéma électrique d'un circuit de détection selon l'invention, d'une surtension sur une borne d'alimentation électrique du circuit intégré,
- la figure 11 représente sous la forme de blocs une variante de réalisation du dispositif de détection représenté sur la figure 3,
- la figure 12 est un schéma électrique d'un circuit de temporisation du dispositif de détection représenté sur la figure 11,
- les figures 13 à 16 sont des schémas électriques de plusieurs modes de réalisation de circuits de contrôle de la tension d'alimentation du circuit intégré, du dispositif de protection selon l'invention.

La figure 2 représente un circuit intégré IC comportant des bornes de connexion d'entrée et/ou sortie Pi et une borne de connexion d'alimentation VDD du circuit intégré.

Selon l'invention, le circuit intégré IC comprend un dispositif de protection LUP contre les déclenchements parasites (latch-up). Le dispositif LUP comprend un dispositif de détection de conditions de génération de déclenchements parasites LUDC et un circuit de contrôle PMC de la tension d'alimentation Vdd du circuit intégré. Le dispositif LUDC fournit un signal de détection LU qui est exploité par le circuit PMC pour contrôler la tension d'alimentation Vdd fournie aux autres fonctions du circuit intégré.

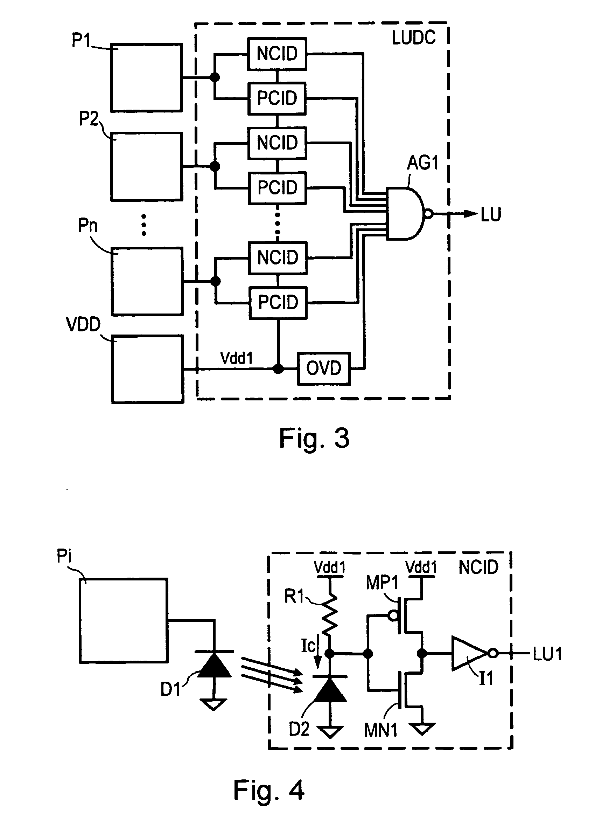

La figure 3 représente un dispositif de détection LUDC selon l'invention, fournissant au circuit intégré IC un signal de détection LU d'au moins une condition de génération d'un déclenchement parasite.

Le dispositif de détection LUDC comprend un circuit de détection d'injection de courant positif PCID et/ou un circuit de détection d'injection de courant négatif NCID, connecté à chaque borne de connexion d'un ensemble de bornes de connexion d'entrée et/ou de sortie P1-Pn du circuit intégré IC, et/ou un circuit de détection de surtensions OVD connecté à la borne de connexion d'alimentation VDD du circuit intégré.

Le dispositif LUDC comprend une porte ET inversée AG1 connectée aux sorties des circuits NCID, PCID et OVD. La sortie de la porte AG1 fournit le signal de détection LU.

Le circuit de détection LUDC est alimenté par une tension Vdd1 provenant directement de la borne de connexion d'alimentation VDD du circuit intégré IC.

Si aucune condition de déclenchement parasite n'est détectée, tous les signaux appliqués en entrée de la porte AG1 sont à 1, et donc le signal de sortie du dispositif LUDC est à 0. Au contraire, si au moins un signal en entrée de la porte AG1 est à 0, le signal LU est à 1 indiquant qu'une condition de déclenchement parasite du circuit intégré a été détectée.

La figure 4 représente un circuit de détection d'injection de courant négatif NCID dans une borne de connexion Pi d'un circuit intégré.

L'injection d'un courant négatif par rapport à la masse est généralement possible au travers d'une région dopée N+ formée dans un substrat P, et connectée à la masse, par exemple la région 7 dans le schéma de la figure 1. Une telle région forme une diode D1 parasite connectée en inverse entre la borne de connexion Pi du circuit intégré et la masse. En outre, la diode D1 est parfois ajoutée pour assurer une protection ESD (ElectroStatic Discharge) dans le cas où la borne Pi forme une entrée et/ou sortie ou une borne d'alimentation du circuit intégré.

Sur la figure 4, le circuit de détection NCID comprend une diode D2 montée en inverse et disposée à proximité de la diode D1. L'anode de la diode D2 est connectée à la masse. La cathode de la diode D2 est connectée à l'entrée d'un inverseur comprenant un transistor MOS à canal P MP1 et un transistor MOS à canal N MN1, et est reliée à la source d'alimentation Vdd1 du circuit intégré par l'intermédiaire d'une résistance R1. L'entrée de l'inverseur est connectée aux grilles des transistors MP1 et MN1. La source du transistor MP1 reçoit la tension d'alimentation Vdd1. La source du transistor MN1 est connectée à la masse. Les drains des transistors MP1 et MN1 sont connectés à l'entrée d'un autre inverseur I1 dont la sortie constitue la sortie du circuit NCID qui fournit un signal de détection d'injection de courant négatif LU1.

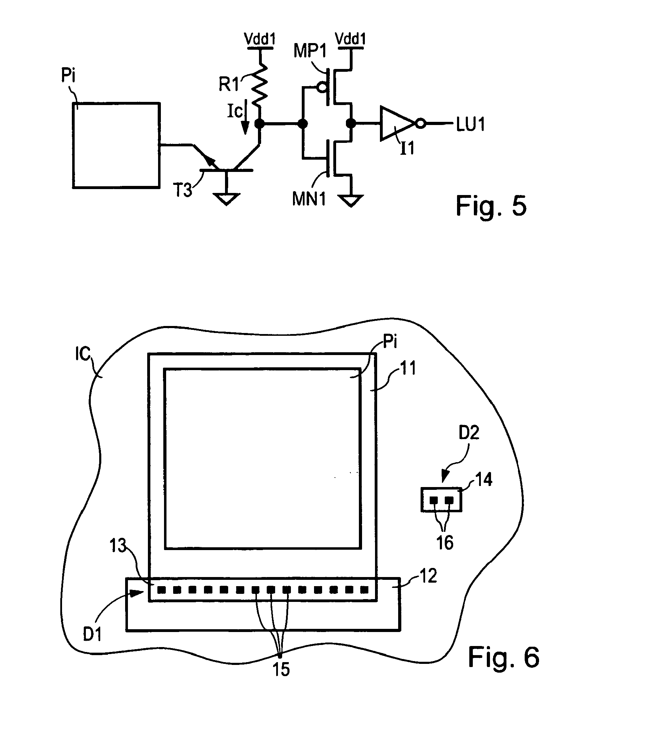

Le circuit NCID de la figure 4 est équivalent au circuit représenté sur la figure 5. Dans le circuit de la figure 5, les diodes D1 et D2 ont été remplacées par un transistor bipolaire T3 de type NPN équivalent aux diodes D1, D2. L'émetteur du transistor T3 est connecté à la borne de connexion Pi, la base du transistor T3 est à la masse, et le collecteur du transistor T3 est connecté à la résistance R1 et aux grilles des transistors MP1 et MN1. Autrement dit, les diodes D1 et D2 sont suffisamment proches l'une de l'autre pour former les jonctions NP et PN d'un transistor bipolaire. La diode D2 qui est ainsi ajoutée pour détecter une injection de courant, forme la jonction collecteur-base du transistor T3, tandis que la diode D1 forme la jonction émetteur-base du transistor T3.

L'intensité du courant Ic circulant dans le collecteur du transistor T3, c'est-à-dire dans la diode de détection D2 varie en fonction du courant total injecté dans la masse du substrat du circuit intégré par la borne de connexion Pi. La loi de variation de l'intensité du courant Ic dépend du gain du transistor T3, et en particulier de la distance entre le collecteur et le point d'injection du courant, et de la forme et des dimensions du collecteur. En raison de ces caractéristiques de distance, de forme et de dimensions (transistor bipolaire latéral avec une longue zone de base), le gain du transistor T3 est typiquement inférieur à 1. La valeur de la résistance R1 est choisie en fonction du seuil d'intensité de courant à détecter. Typiquement, la valeur de la résistance R1 est de quelques kilo Ohm.

Les transistors MP1 et MN1 sont de préférence dimensionnés de manière à ce que le rapport W/L (largeur sur longueur de canal) du transistor MP1 soit bien supérieur à celui du transistor MN1. Ainsi, l'inverseur constitué des transistors MP1 et MN1 bascule lorsque sa tension d'entrée est inférieure ou égale à Vdd1 - Vtp, Vtp étant la tension de seuil du transistor MP1. Le signal de détection LU1 en sortie du circuit NCID, normalement à 1, passe donc à 0 si la relation suivante est vérifiée :

$$R1 \; . \; Ic \; \geq \; |Vtp| \qquad\qquad (1)$$

c'est-à-dire si le courant Ic collecté par la diode D2 est supérieur ou égal à Vtp/R1.

Sans cette contrainte de dimensionnement des transistors MP1 et MN1, le seuil de basculement de l'inverseur constitué des transistors MP1 et MN1 dépend de la tension Vdd.

La notion de proximité des diodes D1 et D2 est illustrée par la figure 6 qui représente en vue de dessus une partie de la face active du circuit intégré IC comportant la borne de connexion Pi. La borne de connexion Pi est réalisée par une métallisation 11 formant une plage de connexion déposée sur la face active du circuit intégré IC, et connectée à au moins une région fortement dopée N+ 12. Sur la figure 6, les contours de la plage de connexion Pi correspondent à une zone de la face active du circuit intégré non recouverte d'un isolant de passivation. La zone de connexion 13 de la zone dopée 12 par la métallisation 11 est reliée à cette dernière par une pluralité de contacts 15, notamment afin de permettre une forte densité de courant. L'interface entre la zone dopée 12 et le substrat de dopage P, forme la diode D1 qui est connectée à la plage de connexion Pi.

La diode D2 est réalisée à proximité de la diode D1, en formant une région dopée N+ 14, et en formant des contacts 16 afin de pouvoir connecter la diode au reste du circuit.

La distance entre les diodes D1 et D2 est déterminée en fonction de la durée de l'injection de courant à détecter et de la vitesse de propagation des charges ainsi injectées dans le circuit intégré.

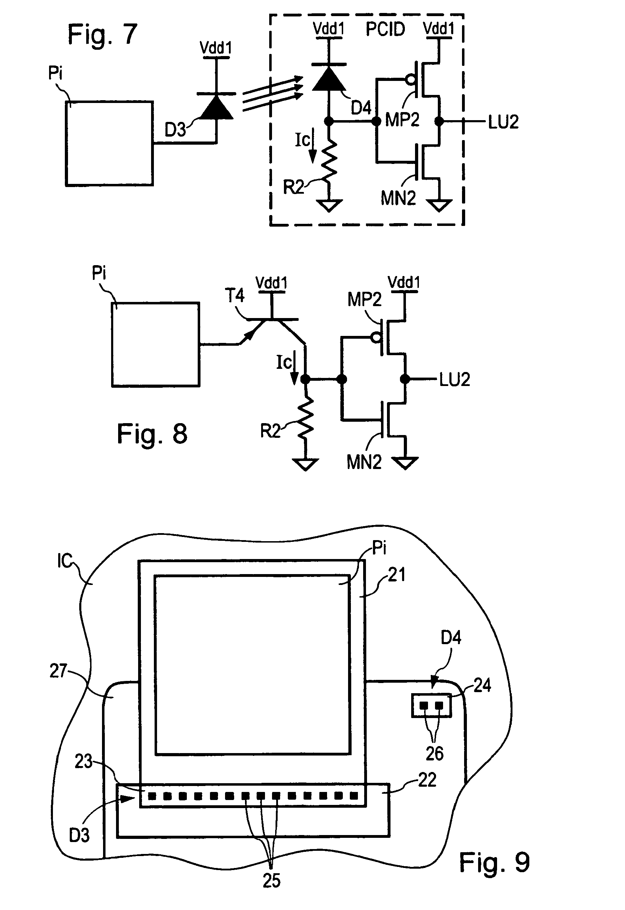

La figure 7 représente un circuit de détection d'injection de courant positif PCID dans une borne de connexion Pi du circuit intégré. L'injection d'un courant positif par rapport à la tension d'alimentation Vdd1 est généralement possible au travers d'une région dopée P+ formée dans un caisson N, et connectée à la source de tension d'alimentation, par exemple la région 4 dans le schéma de la figure 1. Une telle région forme une diode D3 parasite connectée en inverse entre la borne de connexion Pi du circuit intégré et la source d'alimentation Vdd1. En outre, la diode D3 est également parfois ajoutée pour assurer une protection ESD dans le cas où la borne Pi forme une sortie du circuit intégré.

Comme dans le circuit NCID représenté sur la figure 4, le circuit de détection PCID de la figure 7 comprend une diode D4 montée en inverse et disposée à proximité de la diode D3. L'anode de la diode D4 reçoit la tension d'alimentation Vdd1. La cathode de la diode D4 est connectée à l'entrée d'un inverseur comprenant un transistor MOS à canal P MP2 et un transistor MOS à canal N MN2, et reliée à la masse par l'intermédiaire d'une résistance R2. L'entrée de l'inverseur est connectée aux grilles des transistors MP2 et MN2. La source du transistor MN2 est connectée à la masse. La source du transistor MP2 reçoit la tension d'alimentation Vdd1. Les drains des transistors MP2 et MN2 fournissent en sortie du circuit PCID un signal de détection d'injection de courant positif LU2.

Le circuit PCID de la figure 7 est équivalent au circuit représenté sur la figure 8. Dans le circuit de la figure 8, les diodes D3 et D4 ont été remplacées par un transistor bipolaire T4 de type PNP équivalent, dont l'émetteur est connecté à la borne de connexion Pi, la base reçoit la tension d'alimentation Vdd1, et le collecteur est connecté à la résistance R2 et aux grilles des transistors MP2 et MN2. Autrement dit, les diodes D3 et D4 sont suffisamment proches l'une de l'autre pour former des jonctions PN et NP d'un transistor bipolaire. La diode D4 qui est ainsi ajoutée pour détecter une injection de courant, forme la jonction collecteur-base du transistor T4, tandis que la diode D3 forme la jonction émetteur-base du transistor T4.

L'intensité du courant Ic circulant dans le collecteur du transistor T4, c'est-à-dire dans la diode de détection D4, varie en fonction du courant total injecté dans le caisson du circuit intégré par la borne de connexion Pi. La loi de variation de l'intensité du courant Ic dépend de la distance entre le collecteur et le point d'injection du courant, et de la forme et des dimensions du collecteur. En raison de ces caractéristiques de distance, de forme et de dimensions, le gain du transistor T4 est typiquement inférieur à 1. La valeur de la résistance R2 est choisie en fonction du seuil d'intensité de courant à détecter. Typiquement, la valeur de la résistance R2 est de quelques kilo Ohm.

Les transistors MP2 et MN2 sont dimensionnés de préférence de manière à ce que le rapport W/L (largeur sur longueur de canal) du transistor MN2 soit bien supérieur à celui du transistor MP2. Ainsi, l'inverseur constitué des transistors MP2 et MN2 bascule lorsque sa tension d'entrée est supérieure ou égale à Vtn, Vtn étant la tension de seuil du transistor MN2. Le signal de détection LU2 en sortie du circuit PCID, normalement à 1, passe donc à 0 si la relation suivante est vérifiée :

$$R2 \; . \; Ic \geq Vtn \qquad\qquad (2)$$

c'est-à-dire si le courant Ic collecté par la diode D4 est supérieur ou égal à Vtn/R2.

Sans cette contrainte de dimensionnement des transistors MP2 et MN2, le seuil de basculement de l'inverseur constitué des transistors MP2 et MN2 dépend de la tension Vdd.

La notion de proximité des diodes D3 et D4 est illustrée par la figure 9 qui représente en vue de dessus une partie de la face active du circuit intégré IC comportant la borne de connexion Pi. La borne de connexion Pi est réalisée par une métallisation 21 formant une plage de connexion déposée sur la face active du circuit intégré IC. La métallisation 21 est connectée à au moins une région fortement dopée P+ 22 formée dans un caisson dopé N 27. Sur la figure 9, les contours de la plage de connexion Pi correspondent à une zone de la face active du circuit intégré non recouverte d'un isolant de passivation. La zone de connexion 23 de la zone dopée 22 par la métallisation 21 est reliée à cette dernière par une pluralité de contacts 25, notamment afin de permettre une forte densité de courant. L'interface entre la zone dopée 22 et le caisson 27, forme la diode D3 qui est connectée à la plage de connexion Pi.

La diode D4 est réalisée à proximité de la diode D3, en formant une région fortement dopée P+ 24 dans le caisson 27, et en réalisant des contacts 26 afin de pouvoir connecter la diode au reste du circuit.

La distance entre les diodes D3 et D4 est déterminée en fonction de la durée de l'injection de courant à détecter et de la vitesse de propagation des charges ainsi injectées dans le circuit intégré.

Il est à noter que les plages de connexion Pi du circuit intégré IC peuvent n'être associées qu'à un circuit de détection d'injection de courant positif PCID ou négatif NCID, selon la configuration de la plage de connexion. En particulier, si la plage de connexion Pi est connectée uniquement à une région dopée N+ formée dans le substrat, la plage Pi est associée seulement à un circuit NCID. Si la plage de connexion Pi est connectée uniquement à une région dopée P+ formée dans un caisson dopé N, la plage Pi est associée seulement à un circuit PCID. Enfin, si la plage de connexion Pi est connectée à une région dopée P+ formée dans le substrat, et à une région dopée P+ formée dans un caisson dopé N, la plage de connexion est associée à la fois à un circuit NCID et un circuit PCID.

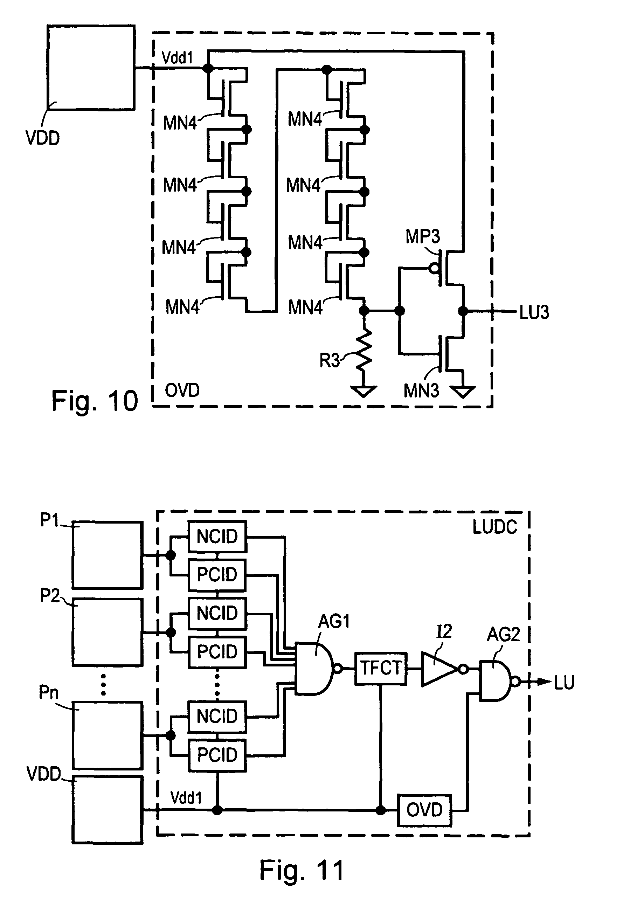

La figure 10 représente un circuit de détection de surtensions OVD dans une borne de connexion d'alimentation VDD du circuit intégré IC. Le circuit OVD comprend plusieurs transistors MOS MN4 montés en diode (grille connectée à la source) agencés en série entre la borne de connexion VDD et la masse par l'intermédiaire d'une résistance R3. Le drain du transistor connecté à la résistance R3 est également connecté à l'entrée d'un inverseur comprenant un transistor MOS à canal P MP3 et un transistor MOS à canal N MN3. L'entrée de l'inverseur est connectée aux grilles des transistors MP3 et MN3. La source du transistor MN3 est connectée à la masse. La source du transistor MP3 reçoit la tension d'alimentation Vdd. Les drains des transistors MP3 et MN3 fournissent en sortie du circuit OVD un signal de détection LU3.

Les transistors MN4 et le transistor MN3 déterminent une tension de seuil Vs au-delà de laquelle l'inverseur constitué des transistors MP3 et MN3 bascule et fournit un signal de détection LU3, normalement à 1, qui passe à 0. La tension de seuil Vs est approximativement égale à n+1 fois la tension de seuil Vtn d'un transistor MOS à canal N, n étant le nombre de transistors MN4 agencés en série (Vs = (n+1).Vtn).

La figure 11 représente une variante du dispositif de détection LUDC selon l'invention. Par rapport au dispositif représenté sur la figure 3, le dispositif de détection LUDC représenté sur la figure 11 comporte en plus un circuit de temporisation TFCT connecté à la sortie de la porte AG1, un inverseur I2 connecté à la sortie du circuit TFCT, et une porte logique AG2 de type ET inversée connectée à la sortie de l'inverseur 12. La sortie de la porte AG2 fournit le signal de détection LU. En outre, la sortie du circuit OVD est connectée, non pas à une entrée de la porte AG1, mais à une autre entrée de la porte AG2.

Dans certaines applications, des injections de courant transitoires peuvent se produire et ne doivent pas être considérées comme des conditions de déclenchement parasite. En effet, certaines de ces conditions comme l'injection de courant dans des bornes d'entrée et/ou de sortie du circuit intégré ne génèrent pas immédiatement un déclenchement parasite, en raison du temps de diffusion des charges minoritaires qui doivent transiter de la diode D1 (ou D3) vers le circuit de détection, qui peut être à 200 μm de la diode. Le circuit TFCT inséré à la sortie de la porte AG1 permet de ne pas détecter ces conditions transitoires. En d'autres termes, les passages à 0 des signaux LU1 et LU2 ayant une durée inférieure à la durée de la temporisation du circuit TFCT ne sont pas pris en compte pour modifier la tension d'alimentation Vdd1 du circuit intégré.

Par contre, des surtensions dans la tension d'alimentation Vdd1 génèrent très rapidement un claquage par effet d'avalanche local. C'est pourquoi le signal de détection LU3 issu du circuit OVD est immédiatement pris en compte en aval du circuit TFCT.

La durée de la temporisation est choisie en fonction de la distance entre la borne de connexion Pi et la diode de détection D2, D4, de la distance par rapport à la borne de connexion Pi des composants à protéger du circuit intégré, et de la vitesse de propagation des charges dans le substrat ou dans le caisson. En d'autres termes, la durée de la temporisation, et la distance entre la diode de détection et la borne de connexion déterminent l'étendue de la zone protégée du circuit intégré autour de la borne de connexion Pi. Plus la durée de la temporisation est longue ou plus la diode de détection est éloignée de la borne de connexion, plus le courant injecté se propage dans le circuit intégré avant qu'une modification soit appliquée sur la tension d'alimentation Vdd du circuit intégré IC.

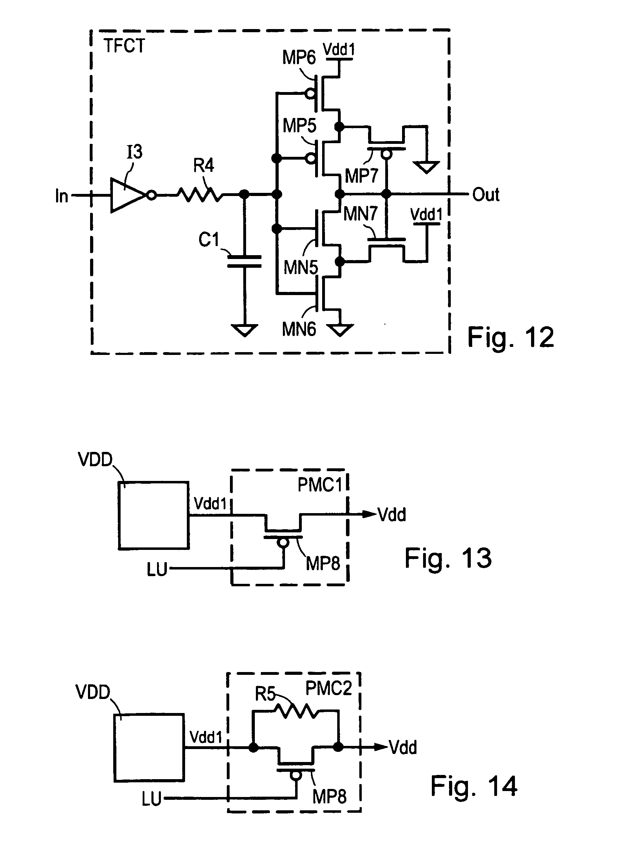

La figure 12 représente un exemple de circuit de temporisation TFCT. Le circuit TFCT comprend un circuit RC, un inverseur I3 connecté entre une entrée In du circuit TFCT et le circuit RC, et un trigger de Schmitt connecté entre le circuit RC et une sortie Out du circuit TFCT.

Le circuit RC comprend une résistance R4 comportant une première borne connectée à la sortie de l'inverseur I3, et un condensateur C1 connecté entre une seconde borne de la résistance R2 et la masse.

Le trigger de Schmitt comprend deux transistors MOS à canal P MP5, MP6, et deux transistors MOS à canal N MN5, MN6. Les grilles des transistors MP5, MP6, MN5, MN6 sont connectées à la seconde borne de la résistance R4 et au condensateur C1. La source du transistor MP6 reçoit la tension d'alimentation Vdd1. La source du transistor MN6 est connectée à la masse. Le trigger de Schmitt comprend également un transistor MP7 dont la source est connectée au drain du transistor MP6 et à la source du transistor MP5, et un transistor MN7 dont la source est connectée à la source du transistor MN5 et au drain du transistor MN6. Les drains des transistors MP5 et MN5 sont connectés à la sortie Out du circuit TFCT et aux grilles des transistors MP7 et MN7.

La constante de temps du circuit TFCT est de l'ordre de R4.C1, et dépend de l'hystérésis du trigger de Schmitt.

Il est à noter que si le dispositif LUDC détecte successivement et sans discontinuité plusieurs injections de courant temporaires, le dispositif va, signaler une détection de déclenchement parasite, malgré la présence du circuit de temporisation TFCT.

La figure 13 représente un premier mode de réalisation d'un circuit de contrôle de la tension d'alimentation du circuit intégré. Le circuit PMC1 représenté sur la figure 13 comprend un transistor MOS à canal P MP8 fonctionnant comme un interrupteur connecté entre la borne de connexion VDD et l'entrée de tension d'alimentation Vdd du circuit intégré. Le transistor MP8 est commandé par le signal de sortie LU du circuit de détection LUDC.

Dès qu'une condition de déclenchement parasite est détectée (signal LU à 1), le transistor MP8 coupe l'alimentation du circuit intégré IC. Dès que cette condition disparaît (signal LU à 0), le transistor MP8 rétablit l'alimentation du circuit intégré.

La figure 14 représente un second mode de réalisation d'un circuit de contrôle de la tension d'alimentation du circuit intégré. Par rapport au circuit PMC1, le circuit PMC2 représenté sur la figure 14 comprend en plus une résistance R5 connectée entre le drain et la source du transistor MP8.

Dès qu'une condition de déclenchement parasite est détectée (signal LU à 1), le transistor MP8 devient non passant. La tension d'alimentation Vdd est alors fournie au circuit intégré IC au travers de la résistance R5. Dès que cette condition disparaît (signal LU à 0), le transistor MP8 court-circuite la résistance R5 et le circuit intégré reçoit alors directement la tension d'alimentation Vdd1 telle qu'elle est fournie à la borne de connexion d'alimentation VDD (Vdd = Vdd1).

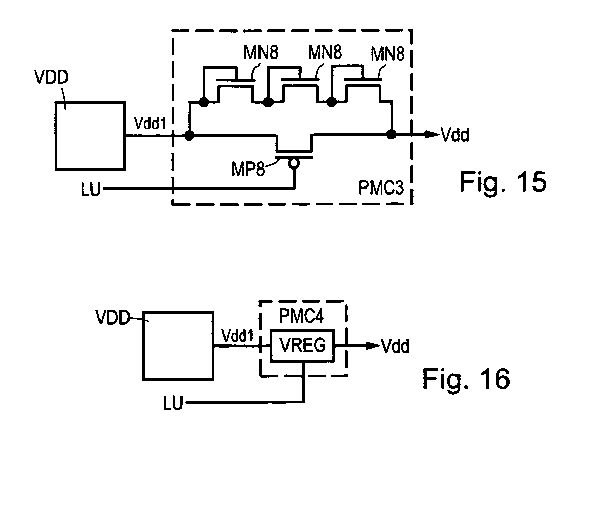

La figure 15 représente un troisième mode de réalisation d'un circuit de contrôle de la tension d'alimentation du circuit intégré. Par rapport au circuit PMC2, le circuit PMC3 représenté sur la figure 15 comprend, à la place de la résistance R5, plusieurs transistors MOS à canal N MN8 montés en diode et agencés en série (trois transistors MN8 dans l'exemple de la figure 15).

Dès qu'une condition de déclenchement parasite est détectée (signal LU à 1), le transistor MP8 devient non passant. La tension d'alimentation Vdd est alors fournie au circuit intégré IC au travers des transistors MN8 qui abaissent la tension Vdd de la tension de seuil Vtn d'un transistor à canal N, multipliée par le nombre n de transistors MN8 (Vdd = Vdd1 - n.Vtn). Dès que cette condition disparaît (signal LU à 0), le transistor MP8 court-circuite les transistors MN8 et le circuit intégré reçoit alors la tension d'alimentation Vdd1 telle qu'elle est fournie à la borne de connexion d'alimentation VDD (Vdd = Vdd1) .

La figure 16 représente un quatrième mode de réalisation d'un circuit de contrôle de la tension d'alimentation du circuit intégré. Le circuit PMC4 représenté sur la figure 16 comprend un régulateur de tension VREG interposé entre la borne de connexion VDD et l'entrée de tension d'alimentation Vdd du circuit intégré. Le régulateur VREG est commandé par le signal de détection LU.

Dès qu'une condition de génération d'un déclenchement parasite est détectée (signal LU à 1), le régulateur de tension VREG est conçu pour abaisser la tension d'alimentation Vdd à une valeur minimum.

Certains circuits intégrés sont équipés d'un tel régulateur de tension. Le mode de réalisation de la figure 16 prévoit en fait d'exploiter la présence d'un tel régulateur de tension pour ajuster la tension d'alimentation du circuit intégré à une valeur minimum lorsqu'une condition de déclenchement parasite est détectée.

Il apparaîtra clairement à l'homme de l'art que l'invention est susceptible de diverses variantes et applications. Ainsi, l'invention n'est pas limitée à un circuit intégré comprenant à la fois un dispositif de détection d'une condition de déclenchement parasite et un dispositif de contrôle de la tension d'alimentation du circuit intégré. En effet, le circuit intégré peut ne pas comprendre de dispositif de contrôle de la tension d'alimentation, et fournir à l'extérieur le signal de détection LU qui est pris en compte par l'alimentation externe du circuit intégré.

Par ailleurs, la fonction de détection de conditions de déclenchement parasite peut être réalisée sans détecter de surtensions sur la borne de connexion d'alimentation du circuit intégré, de sorte que la prévision d'un circuit de détection de surtensions OVD est optionnelle.

**Revendications**

1. Procédé de protection d'un circuit intégré (IC), **caractérisé en ce qu'**il comprend des étapes consistant à détecter un courant dans une diode (D2, D4) formée à proximité d'une borne de connexion (Pi) du circuit intégré, le courant détecté variant en fonction d'un courant injecté dans la borne de connexion, et modifier un paramètre de tension d'alimentation (Vdd) du circuit intégré (IC) si le courant détecté est supérieur à un seuil d'intensité de courant, pour empêcher un établissement permanent d'une condition de déclenchement parasite.

2. Procédé selon la revendication 1, dans lequel le courant détecté dans la diode (D4) varie en fonction d'un courant positif (Ic) injecté dans la borne de connexion.

3. Procédé selon la revendication 1 ou 2, dans lequel le courant détecté dans la diode (D2) varie en fonction d'un courant négatif (Ic) injecté dans la borne de connexion.

4. Procédé selon l'une des revendications 1 à 3, dans lequel la modification d'un paramètre de tension d'alimentation

(Vdd) du circuit intégré (IC) est effectuée seulement si le courant détecté est toujours supérieur au seuil d'intensité de courant à l'échéance d'une temporisation.

5. Procédé selon l'une des revendications 1 à 4, comprenant la détection d'une surtension apparaissant dans une borne de connexion d'alimentation (VDD) du circuit intégré (IC).

6. Procédé selon l'une des revendications 1 à 5, dans lequel la modification d'un paramètre de tension d'alimentation (Vdd) du circuit intégré (IC) comprend la coupure de la tension d'alimentation du circuit intégré tant qu'une condition de déclenchement parasite est présente.

7. Procédé selon l'une des revendications 1 à 6, dans lequel la modification d'un paramètre de tension d'alimentation (Vdd) du circuit intégré (IC) comprend un abaissement de la tension d'alimentation du circuit intégré tant qu'une condition de déclenchement parasite est présente.

8. Procédé selon l'une des revendications 1 à 7, dans lequel la modification d'un paramètre de tension d'alimentation (Vdd) du circuit intégré (IC) comprend la fourniture de la tension d'alimentation du circuit intégré au travers d'une résistance (R5) tant qu'une condition de déclenchement parasite est présente.

9. Dispositif de protection d'un circuit intégré (IC), comprenant un dispositif de détection (LUDC) d'une condition de déclenchement parasite, et un dispositif de contrôle (PMC) d'une tension d'alimentation (Vdd) du circuit intégré (IC), **caractérisé en ce que** le dispositif de détection (LUDC) comprend une diode (D2, D4) formée à proximité d'une borne de connexion (Pi) du circuit intégré (IC) et un circuit de détection de courant (NCID, PCID) pour détecter un courant traversant la diode, le courant détecté variant en fonction d'un courant injecté dans la borne de connexion, le dispositif de contrôle (PMC) étant configuré pour modifier un paramètre de la tension d'alimentation (Vdd) du circuit intégré si le courant détecté est supérieur à un seuil d'intensité de courant, afin d'empêcher un établissement permanent du déclenchement parasite.

10. Dispositif selon la revendication 9, dans lequel le courant détecté dans la diode (D2) varie en fonction d'un courant négatif (Ic) injecté dans une borne de connexion (Pi) du circuit intégré (IC).

11. Dispositif selon l'une des revendications 9 à 10, dans lequel le courant détecté dans la diode (D4) varie en fonction d'un courant positif (Ic) injecté dans une borne de connexion (Pi) du circuit intégré (IC).

12. Dispositif selon l'une des revendications 9 à 11, dans lequel le dispositif de détection d'une condition de déclenchement parasite (LUDC) comprend pour chaque borne de connexion (Pi) du circuit intégré (IC), un circuit de détection (NCID) d'une injection de courant négatif (Ic) dans la borne de connexion, et/ou un circuit de détection (PCID) d'une injection de courant positif (Ic) dans la borne de connexion.

13. Dispositif selon l'une des revendications 9 à 12, dans lequel le dispositif de détection d'une condition de déclenchement parasite (LUDC) comprend un circuit de temporisation (TFCT) pour prendre en compte une détection d'injection de courant dans une borne de connexion (Pi) du circuit intégré (IC), seulement si à la fin d'une durée de temporisation, une injection de courant est toujours détectée.

14. Dispositif selon l'une des revendications 9 à 13, dans lequel le dispositif de détection d'une condition de déclenchement parasite (LUDC) comprend un circuit de détection (OVD) d'une surtension apparaissant dans une borne de connexion d'alimentation (VDD) du circuit intégré (IC).

15. Dispositif selon l'une des revendications 9 à 14, dans lequel le dispositif de contrôle de tension d'alimentation (PMC1) comprend des moyens de coupure (MP8) de la tension d'alimentation (Vdd) du circuit intégré (IC) tant qu'une condition de déclenchement parasite est présente.

16. Dispositif selon l'une des revendications 9 à 15, dans lequel le dispositif de contrôle de tension d'alimentation (PMC3) comprend un abaisseur de tension (MN8) pour abaisser la tension d'alimentation (Vdd) du circuit intégré (IC) tant qu'une condition de déclenchement parasite est présente.

17. Dispositif selon l'une des revendications 9 à 16, dans lequel le dispositif de contrôle de tension d'alimentation (PMC2) comprend une résistance (R5) au travers de laquelle la tension d'alimentation (Vdd) est fournie au circuit intégré (IC) tant qu'une condition de déclenchement parasite est présente.

**18.** Dispositif selon l'une des revendications 9 à 17, dans lequel le dispositif de contrôle de tension d'alimentation (PMC4) comprend un régulateur de tension (VREG) qui abaisse la tension d'alimentation (Vdd1) du circuit intégré (IC) à une valeur minimum tant qu'une condition de déclenchement parasite est présente.

**19.** Circuit intégré comprenant un dispositif de protection selon l'une des revendications 9 à 18.

**Claims**

**1.** Method for protecting an integrated circuit (IC), **characterized in that** it comprises detecting a current in a diode (D2, D4) formed near a connection terminal (Pi) of the integrated circuit, the current detected varying as a function of a current injected into the connection terminal, and modifying a supply voltage (Vdd) parameter of the integrated circuit (IC) if the current detected is higher than a current intensity threshold, so as to prevent a latch up condition from permanently establishing.

**2.** Method according to claim 1, wherein the current detected in the diode (D4) varies as a function of a positive current (Ic) injected into the connection terminal.

**3.** Method according to claim 1 or 2, wherein the current detected in the diode (D2) varies as a function of a negative current (Ic) injected into the connection terminal.

**4.** Method according to one of claims 1 to 3, wherein modifying a supply voltage (Vdd) parameter of the integrated circuit (IC) is performed only if the current detected is still higher to the current intensity threshold at the end of a time out.

**5.** Method according to one of claims 1 to 4, comprising detecting an overvoltage appearing in a supply connection terminal (VDD) of the integrated circuit (IC).

**6.** Method according to one of claims 1 to 5, wherein modifying a supply voltage (Vdd) parameter of the integrated circuit (IC) comprises cutting the supply voltage of the integrated circuit as long as a latch up condition is present.

**7.** Method according to one of claims 1 to 6, wherein modifying a supply voltage (Vdd) parameter of the integrated circuit (IC) comprises a decrease of the supply voltage of the integrated circuit as long as a latch up condition is present.

**8.** Method according to one of claims 1 to 7, wherein modifying a supply voltage (Vdd) parameter of the integrated circuit (IC) comprises supplying the supply voltage of the integrated circuit through a resistor (R5) as long as a latch up condition is present.

**9.** Device for protecting an integrated circuit (IC), comprising a detection device (LUDC) for detecting a latch up condition, and a control device (PMC) for controlling a supply voltage (Vdd) of the integrated circuit (IC), **characterized in that** the detection device (LUDC) comprises a diode (D2, D4) formed near a connection terminal (Pi) of the integrated circuit (IC) and a current detection circuit (NCID, PCID) for detecting a current passing through the diode, the current detected varying as a function of a current injected into the connection terminal, the control device (PMC) being configured to modify a supply voltage (Vdd) parameter of the integrated circuit if the current detected is higher than a current intensity threshold, so as to prevent the latch up condition from permanently establishing.

**10.** Device according to claim 9, wherein the current detected in the diode (D2) varies as a function of a negative current (Ic) injected into a connection terminal (Pi) of the integrated circuit (IC).

**11.** Device according to one of claims 9 to 10, wherein the current detected in the diode (D4) varies as a function of a positive current (Ic) injected into a connection terminal (Pi) of the integrated circuit (IC).

**12.** Device according to one of claims 9 to 11, wherein the device for detecting a latch up condition (LUDC) comprises for each connection terminal (Pi) of the integrated circuit (IC), a detection circuit (NCID) for detecting an injection of negative current (Ic) into the connection terminal, and/or a detection circuit (PCID) for detecting an injection of positive current (Ic) into the connection terminal.

**13.** Device according to one of claims 9 to 12, wherein the device for detecting a latch up condition (LUDC) comprises a time delay circuit (TFCT) for acknowledging a detection of current injection into a connection terminal (Pi) of the integrated circuit (IC), only if at the end of a time out period, a current injection is still detected.

**14.** Device according to one of claims 9 to 13, wherein the device for detecting a latch up condition (LUDC) comprises a detection circuit (OVD) for detecting an overvoltage appearing in a supply connection terminal (VDD) of the integrated circuit (IC).

**15.** Device according to one of claims 9 to 14, wherein the supply voltage control device (PMC1) comprises cutting means (MP8) for cutting the supply voltage (Vdd) of the integrated circuit (IC) as long as a latch up condition is present.

**16.** Device according to one of claims 9 to 15, wherein the supply voltage control device (PMC3) comprises a decrease voltage adapter (MN8) for decreasing the supply voltage (Vdd) of the integrated circuit (IC) as long as a latch up condition is present.

**17.** Device according to one of claims 9 to 16, wherein the supply voltage control device (PMC2) comprises a resistor (R5) through which the supply voltage (Vdd) is provided to the integrated circuit (IC) as long as a latch up condition is present.

**18.** Device according to one of claims 9 to 17, wherein the supply voltage control device (PMC4) comprises a voltage regulator (VREG) which decreases the supply voltage (Vdd1) of the integrated circuit (IC) to a minimum value as long as a latch up condition is present.

**19.** Integrated circuit comprising a protection device according to one of claims 9 to 18.

**Patentansprüche**

**1.** Verfahren zum Schutz eines integrierten Schaltkreises (IC), **dadurch gekennzeichnet, dass** es Schritte umfasst, die darin bestehen, einen Strom in einer in der Nähe einer Anschlussklemme (Pi) des integrierten Schaltkreises ausgebildeten Diode (D2, D4) zu detektieren, wobei der detektierte Strom in Abhängigkeit eines in die Anschlussklemme injizierten Stroms variiert, und einen Parameter der Versorgungsspannung (Vdd) des integrierten Schaltkreises (IC) zu ändern, wenn der detektierte Strom eine Stromstärkenschwelle übersteigt, um eine permanente Herstellung einer Störauslösungsbedingung zu verhindern.

**2.** Verfahren nach Anspruch 1, bei dem der in der Diode (D4) detektierte Strom in Abhängigkeit eines in die Anschlussklemme injizierten positiven Stroms (Ic) variiert.

**3.** Verfahren nach Anspruch 1 oder 2, bei dem der in der Diode (D2) detektierte Strom in Abhängigkeit eines in die Anschlussklemme injizierten negativen Stroms (Ic) variiert.

**4.** Verfahren nach einem der Ansprüche 1 bis 3, bei dem die Änderung eines Parameters der Versorgungsspannung (Vdd) des integrierten Schaltkreises (IC) nur dann vorgenommen wird, wenn der detektierte Strom bei Ende einer Verzögerung immer noch die Stromstärkenschwelle übersteigt.

**5.** Verfahren nach einem der Ansprüche 1 bis 4, umfassend die Detektion einer in einer Versorgungsklemme (VDD) des integrierten Schaltkreises (IC) auftretenden Überspannung.

**6.** Verfahren nach einem der Ansprüche 1 bis 5, bei dem die Änderung eines Parameters der Versorgungsspannung (Vdd) des integrierten Schaltkreises (IC) die Unterbrechung der Versorgungsspannung des integrierten Schaltkreises umfasst und zwar solange eine Störauslösungsbedingung vorliegt.

**7.** Verfahren nach einem der Ansprüche 1 bis 6, bei dem die Änderung eines Parameters der Versorgungsspannung (Vdd) des integrierten Schaltkreises (IC) eine Senkung der Versorgungsspannung des integrierten Schaltkreises umfasst und zwar solange eine Störauslösungsbedingung vorliegt.

**8.** Verfahren nach einem der Ansprüche 1 bis 7, bei dem die Änderung eines Parameters der Versorgungsspannung (Vdd) des integrierten Schaltkreises (IC) die Zuführung der Versorgungsspannung des integrierten Schaltkreises über einen Widerstand (R5) umfasst und zwar solange eine Störauslösungsbedingung vorliegt.

9. Vorrichtung zum Schutz eines integrierten Schaltkreises (IC), umfassend eine Einrichtung zur Detektion (LUDC) einer Störauslösungsbedingung, sowie eine Einrichtung zur Kontrolle (PMC) einer Versorgungsspannung (Vdd) des integrierten Schaltkreises (IC),
**dadurch gekennzeichnet, dass** die Detektionseinrichtung (LUDC) eine in der Nähe einer Anschlussklemme (Pi) des integrierten Schaltkreises (IC) ausgebildete Diode (D2, D4) umfasst, sowie einen Stromdetektionskreis (NCID, PCID), um einen durch die Diode fließenden Strom zu detektieren, wobei der detektierte Strom in Abhängigkeit eines in die Anschlussklemme injizierten Stroms variiert und die Kontrolleinrichtung (PMC) so konfiguriert ist, dass ein Parameter der Versorgungsspannung (Vdd) des integrierten Schaltkreises geändert wird, wenn der detektierte Strom eine Stromstärkenschwelle übersteigt, um eine permanente Herstellung der Störauslösung zu verhindern.

10. Vorrichtung nach Anspruch 9, bei der der in der Diode (D2) detektierte Strom in Abhängigkeit eines in eine Anschlussklemme (Pi) des integrierten Schaltkreises (IC) injizierten negativen Stroms (Ic) variiert.

11. Vorrichtung nach einem der Ansprüche 9 bis 10, bei der der in der Diode (D4) detektierte Strom in Abhängigkeit eines in eine Anschlussklemme (Pi) des integrierten Schaltkreises (IC) injizierten positiven Stroms (Ic) variiert.

12. Vorrichtung nach einem der Ansprüche 9 bis 11, bei der die Einrichtung zur Detektion einer Störauslösungsbedingung (LUDC) für jede Anschlussklemme (Pi) des integrierten Schaltkreises (IC) einen Kreis zur Detektion (NCID) einer Injektion von negativem Strom (Ic) in die Anschlussklemme und/oder einen Kreis zur Detektion (PCID) einer Injektion von positivem Strom (Ic) in die Anschlussklemme umfasst.

13. Vorrichtung nach einem der Ansprüche 9 bis 12, bei der die Einrichtung zur Detektion einer Störauslösungsbedingung (LUDC) einen Verzögerungskreis (TFCT) umfasst, um eine Detektion einer Strominjektion in eine Anschlussklemme (Pi) des integrierten Schaltkreises (IC) nur dann zu berücksichtigen, wenn bei Ende einer Verzögerungsdauer immer noch eine Strominjektion detektiert wird.

14. Vorrichtung nach einem der Ansprüche 9 bis 13, bei der die Einrichtung zur Detektion einer Störauslösungsbedingung (LUDC) einen Kreis zur Detektion (OVD) einer in einer Versorgungsklemme (VDD) des integrierten Schaltkreises (IC) auftretenden Überspannung umfasst.

15. Vorrichtung nach einem der Ansprüche 9 bis 14, bei der die Einrichtung zur Kontrolle der Versorgungsspannung (PMC1) Mittel (MP8) umfasst, um die Versorgungsspannung (Vdd) des integrierten Schaltkreises (IC) zu unterbrechen, solange eine Störauslösungsbedingung vorliegt.

16. Vorrichtung nach einem der Ansprüche 9 bis 15, bei der die Einrichtung zur Kontrolle der Versorgungsspannung (PMC3) einen Spannungsminderer (MN8) umfasst, um die Versorgungsspannung (Vdd) des integrierten Schaltkreises (IC) zu mindern, solange eine Störauslösungsbedingung vorliegt.

17. Vorrichtung nach einem der Ansprüche 9 bis 16, bei der die Einrichtung zur Kontrolle der Versorgungsspannung (PMC2) einen Widerstand (R5) umfasst, über den die Versorgungsspannung (Vdd) dem integrierten Schaltkreis (IC) zugeführt wird, solange eine Störauslösungsbedingung vorliegt.

18. Vorrichtung nach einem der Ansprüche 9 bis 17, bei der die Einrichtung zur Kontrolle der Versorgungsspannung (PMC4) einen Spannungsregler (VREG) umfasst, der die Versorgungsspannung (Vdd1) des integrierten Schaltkreises (IC) auf einen Mindestwert herabsetzt, solange eine Störauslösungsbedingung vorliegt.

19. Integrierter Schaltkreis umfassend eine Schutzvorrichtung nach einem der Ansprüche 9 bis 18.

Fig. 1

Fig. 2

Fig. 3

Fig. 4

Pi

Vdd1    MP1    Vdd1

R1

Ic

T3

MN1

I1

LU1

**Fig. 5**

IC

Pi

11

D2

14

13

16

12

15

D1

**Fig. 6**

Fig. 7

Fig. 8

Fig. 9

Fig. 10

Fig. 11

Fig. 12

Fig. 13

Fig. 14

Fig. 15

Fig. 16

**EP 1 811 568 B1**

**RÉFÉRENCES CITÉES DANS LA DESCRIPTION**

**Documents brevets cités dans la description**

- JP 06273481 B
- US 5212616 A